# EUROPEAN PATENT APPLICATION

(11) **EP 2 256 507 A1**
(43) Date of publication of application: **01.12.2010**
(21) Application number: 09161259.8
(22) Date of filing: 27.05.2009
(51) Int. Cl.: G01R 29/08

(54) **A dual deformable reverberation chamber**

(71) Applicant: Thales Nederland B.V., 7550 GD Hengelo (NL)
(72) Inventor: Leferink, Frank, 7587AP, DE LUTTE (NL)
(74) Representative: Lucas, Laurent Jacques

(57) **Abstract**

There is disclosed an arrangement for measuring the effectiveness of a shielding material against electromagnetic fields.

The arrangement comprises a first and a second reverberation chamber sharing a common wall. The common wall is partly made of the shielding material. A first antenna is arranged in the first reverberation chamber. The first antenna transmits an electromagnetic field. The electromagnetic field goes through the shielding material to enter the second reverberation chamber. A second antenna arranged in the second reverberation chamber receives the electromagnetic field.

The second reverberation chamber comprises at least one deformable wall, so as to mix the electromagnetic field before it is received by the second antenna.

## Description

### Technical field :

The present invention relates to a dual deformable reverberation chamber for measuring the effectiveness of a shielding material against electromagnetic fields. The invention is particularily applicable to the domain of shielding against electromagnetic fields.

### Prior art and technical problem :

Various materials may help shielding against electromagnetic fields. These materials may include metal sheets, metal paint on composite materials, conductive composite materials, metalised fabrics, honeycomb structures or perforated metal sheets. Various interconnection techniques between materials may help shielding against electromagnetic fields. These techniques may include the use of gaskets, screws, rivets or welding.

The shielding effectiveness may depend on the strength of the electromagnetic field, i.e. whether it is high or low strength field. Thus, evaluating the shielding effectiveness as a function of the field strength is essential to make efficient use of the materials and techniques for shielding.

In a first attempt, materials have been inserted in a wall between two shielded enclosures to measure their shielding effectiveness. For example, the Military Standard MIL-STD 285 released in 1956 describes such a method of attenuation measurements for enclosures, electromagnetic shielding, for electronic test purposes. However, these attempts failed at high frequencies.

In 1971, a technique was published under MIL-STD 1377, which made use of a mechanic rotating paddle wheel in a shielded enclosure to measure the shielding of a missile. The paddle wheel was used as mode-stirring means. The paddle wheel enabled to mix the electromagnetic field, in such a way that the minimum shielding effectiveness, i.e. the highest leak, could be measured.

In 1985, the applicant has measured the shielding effectiveness of materials inserted between two large chambers. One of the chambers had the property to reverberate the electromagnetic waves emitted from the inside. Provided with a mode-stirrer inside, a reverberation chamber creates a periodic electromagnetic environment, which is randomly polarised (i.e. the phase between all waves is random), spatialy uniform (i.e. the energy density in the chamber is uniform everywhere) and isotropic (i.e. the energy flow in all directions is the same). In 1993, the applicant published its results under "Accurate Shielding Effectiveness Measurements using a Reverberation Chamber", (Frank Leferink, Ben Puylaert, 10th Internation Zurich Symposium and Technical Exhibition on Electromagnetic Compatibility, 1993, page 635-640).

In the USA, it has been developed a box which was in itself reverberant and provided with a mode-stirrer inside. The material to be tested was inserted in a wall of the box. The box was arranged in a larger reverberation chamber provided with a mode-stirrer inside.

Unfortunately, a major drawback of the aforementioned reverberation chambers is the time needed to setup a test. Indeed, for every frequency, the mode-stirrer, e.g. the paddle wheel, has to make a rotation in the first chamber, for every position of the mode-stirrer in the second chamber. Yet another drawback of the aforementioned reverberation chambers is that they are large chambers. As a result, only low field strengths can be tested at a low cost. Indeed, testing high field strengths and thus high dynamic range of the shielding effectiveness in these large reverberation chambers requires expensive power amplifiers. As a consequence, setting up a test happens to be difficult.

The applicant filed the international patent application published under WO 00/34795, which focuses on developing a high field strength for testing equipment. This application describes a large reverberation chamber without a mode-stirrer inside. It is a flexible reverberation chamber, in which the fields are mixed by moving the walls. However, it does not enable to measure the effectiveness of a shielding material against electromagnetic fields.

### Summary of claims :

The present invention aims to provide an arrangement, which may be used to facilitate the test setup and perform measurements rapidly. At its most general, the invention proposes an arrangement for measuring the effectiveness of a shielding material against electromagnetic fields. The arrangement comprises a first and a second reverberation chamber sharing a common wall. The common wall is partly made of the shielding material. A first antenna is arranged in the first reverberation chamber. The first antenna transmits an electromagnetic field. The electromagnetic field goes through the shielding material to enter the second reverberation chamber. A second antenna arranged in the second reverberation chamber receives the electromagnetic field. The second reverberation chamber comprises at least one deformable wall, so as to mix the electromagnetic field before it is received by the second antenna.

In a preferred embodiment, the deformable wall may be made of a flexible material which is moved mechanically. For example, the second reverberation chamber may be a tent made of a metalised fabric.

In a further preferred embodiment, the first reverberation chamber may also comprise at least one deformable wall, which may be made of a flexible material and moved mechanically.

In another preferred embodiement, the first reverberation chambers may be a tent made of a metalised fabric, of which at least one wall may be moved mechanically.

### Advantages :

Thus, a further advantage provided by the present invention in any of its aspects is that it provides smaller reverberation chambers, hereby enabling to perform tests at higher field strengths.

### Drawings :

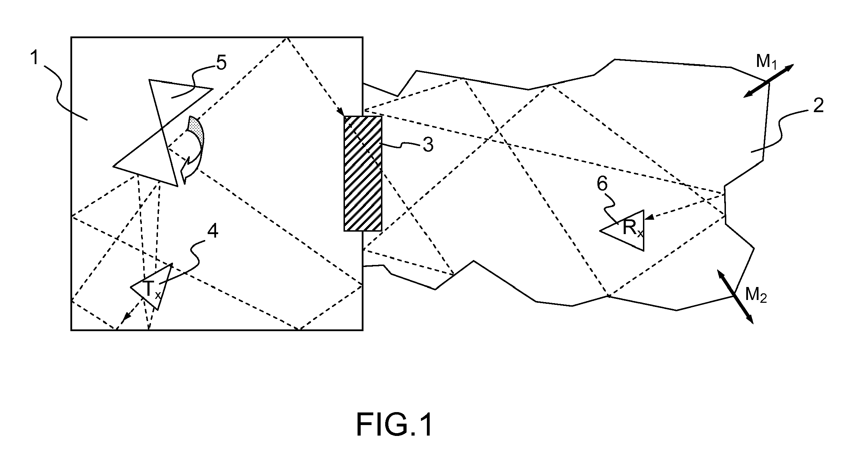

Non-limiting examples of the invention are described below with reference to the accompanying figure 1, which schematically illustrates an exemplary arrangement according to the invention.

### Description of invention referring to figures :

Figure 1 schematically illustrates an exemplary arrangement according to the invention. A first reverberation chamber 1 may share a common wall with a second reverberation chamber 2. For example, a hatch 3 comprising a shielding gasket may be under test. The hatch 3 enables to go from the first reverberation chamber 1 to the second reverberation chamber 2, through the common wall. Advantageously, the reverberation chamber 2 may be a flexible chamber, its walls being made of a flexible material. Advantageously, the reverberation chamber 2 may be a tent comprising a metalised fabric supported by an external frame. A transmit antenna 4 and a rotating mode-stirrer 5 may be arranged in the first reverberation chamber 1. A receive antenna 6 may be arranged in the second reverberation chamber 2.

A beam may be emitted by the antenna 4 and then reflected several times either by the walls of the reverberation chamber 1 or by the rotating mode-stirrer 5. Then, the beam may reach the hatch 3 and partly go through its shielding gasket, hereby entering the second reverberation chamber 2. Advantageously, the flexible walls of the reverberation chamber 2 may be moved mechanically, as illustrated on Figure 1 by two arrows M1 and M2. Thus, inside the reverberation chamber 2, the beam may be reflected several times by the moving walls. Moving walls creates a homogeneous field inside the reverberation chamber 2, with high uniformity and high field strength at lower frequencies than conventional mode-stirred reverberation chambers. As a comparison, the mode-stirrer 5 needs 360 degree of rotation to achieve an uniform field in the first reverberation chamber 1. With only slight wall movements, this is achieved much faster in the reverberation chamber 2. The applicant has measured that, to achieve acceptable uniformity in the chamber 2, approximately 1 millisecond is need, compared to several hundreds milliseconds in a conventional mode-stirred reverberation chamber such as the chamber 1. Hereby, at every frequency the electromagnetic field is efficiently and rapidly mixed in the reverberation chamber 2. Finally, the beam may reach the receive antenna 6.

Alternatively, the two reverberation chambers 1 and 2 may be two tents comprising flexible moving walls. Hereby, at every frequency the electromagnetic field may be mixed efficiently and rapidly in both reverberation chambers 1 and 2. Then, the measurement time may be drastically reduced. Because the field is shielded twice, the flexible chambers can be made of simple material, for instance creating a shielding effectiveness from inside to outside of 60 decbels (dB). Then the materials which is mounted in the common wall can be tested much more than 120 dB. It is worth noting that it is not needed that the common wall is solid.

Hereby, the exemplary embodiment of Figure 1 provides a simple and easy arrangement that facilitates the test setup and enables to perform measurements rapidly.

### Further advantages:

Yet another advantage of the present invention is that mounting the material to be tested in the wall between the two chambers is very easy. Moreover, the invention may be used for evaluating the transfer functions of antennas.

## Claims

1. An arrangement for measuring the effectiveness of a shielding material (3) against electromagnetic fields, the arrangement comprising a first (1) and a second (2) reverberation chamber sharing a common wall, the common wall being partly made of the shielding material (3), a first antenna (4) arranged in the first reverberation chamber (1), the first antenna (4) transmitting an electromagnetic field, the electromagnetic field going through the shielding material to enter the second reverberation chamber (2), a second antenna (6) arranged in the second reverberation chamber (2) receiving the electromagnetic field, the arrangement being **characterized in that** the second reverberation chamber (2) comprises at least one deformable wall, so as to mix the electromagnetic field before it is received by the second antenna (6).

2. An arrangement as claimed in Claim 1, **characterized in that** the deformable wall is made of a flexible material, which is moved mechanically.

3. An arrangement as claimed in Claim 2, **characterized in that** the second reverberation chamber (2) is a tent made of a metalised fabric.

4. An arrangement as claimed in Claim 1, **characterized in that** the first reverberation chamber (1) comprises at least one deformable wall.

5. An arrangement as claimed in Claim 4, **characterized in that** the deformable wall of the first reverberation chamber is made of a flexible material, which is moved mechanically.

6. An arrangement as claimed in Claim 5, **characterized in that** the first reverberation chambers (1) is a tent made of a metalised fabric.
